# EUROPÄISCHE PATENTSCHRIFT

(11) **EP 3 317 968 B1**
(45) Veröffentlichungstag und Bekanntmachung des Hinweises auf die Patenterteilung: **22.11.2023**
(21) Anmeldenummer: 16739425.3
(22) Anmeldetag: 29.06.2016
(51) Int. Cl.: H03K 17/955, H03K 17/96, G06F 3/041, G06F 3/044

(54) **VERFAHREN ZUM MESSEN EINES KAPAZITÄTSWERTES**
METHOD FOR MEASURING A CAPACITANCE VALUE
PROCÉDÉ DE MESURE D'UNE VALEUR DE CAPACITÉ

(30) Priorität: 01.07.2015 DE 102015008485
(43) Veröffentlichungstag der Anmeldung: 09.05.2018
(73) Patentinhaber: KOSTAL Automobil Elektrik GmbH & Co. KG, 58513 Lüdenscheid (DE)
(72) Erfinder: LEXOW, Carl Christian, 51230 Faux-Fresnay (FR)
(74) Vertreter: Kerkmann, Detlef
(86) Internationale Anmeldenummer: PCT/EP2016/065190
(87) Internationale Veröffentlichungsnummer: WO 2017/001510

(56) Entgegenhaltungen:
- EP-A1- 2 717 136
- DE-U1- 29 924 441
- DE-U1- 29 924 441
- US-A1- 2010 181 180
- US-A1- 2011 261 006
- US-B1- 6 466 036

## Beschreibung

Die Erfindung betrifft ein Verfahren zum Messen eines Kapazitätswertes C_{M} eines kapazitiven Sensorelements mittels eines Integrationsverfahrens, wobei ein Anschluss des Sensorelements mit einem ersten Anschluss eines Integrationskondensators mit einem bekannten Kapazitätswert C_{I}, welcher groß gegenüber dem Kapazitätswert C_{M} des Sensorelements ist, an einem gemeinsamen Schaltungsknoten elektrisch verbunden ist, und wobei nach einer Zahl IZ durchgeführter Integrationszyklen eine an dem Integrationskondensator anliegende Spannung U_{CI} mittels eines A/D-Wandlers gemessen wird.

Verfahren der hier angesprochenen Art werden verwendet um kapazitive Berührungs- bzw. Annäherungssensoren auszuwerten. Ein solcher Sensor kann die Gegenwart und bei entsprechender Ausgestaltung auch den Ort einer Berührung oder der Annäherung durch ein Objekt, wie zum Beispiel einen Finger des Benutzers oder einen Stift, innerhalb eines empfindlichen Bereichs detektieren. Der berührungsempfindliche Bereich kann dabei beispielsweise einen Anzeigebildschirm überlagern. In einer Anzeigeanwendung kann es der Berührungs- bzw. Annäherungssensor dem Benutzer ermöglichen, direkt mit dem, was auf dem Bildschirm dargestellt wird, zu interagieren, und nicht nur indirekt mittels einer Maus oder einem ähnlichen Eingabegerät.

Es gibt eine Anzahl verschiedener Arten von Berührungssensoren, wie zum Beispiel resistive Berührungssensoren, Berührungssensoren mit akustischen Oberflächenwellen und kapazitive Berührungssensoren, wobei letztgenannte, mit denen eben insbesondere auch schon eine bloße Annäherung erfasst werden kann, inzwischen die größte Verbreitung erfahren haben.

Wenn ein Objekt die Oberfläche eines kapazitiven Berührungssensors berührt oder in dessen Nähe kommt, tritt eine Änderung des Kapazitätswertes des Sensors auf. Aufgabe eines zugeordneten Sensorsteuergerätes bzw. des durch dieses verwendeten Messverfahrens ist es, diese Kapazitätsänderung zu verarbeiten, um die diese auslösende Berührung oder Annäherung zu erfassen. Die besondere Schwierigkeit hierbei besteht darin, dass die Kapazitätswerte der Sensoren und insbesondere die zu erfassenden Änderungen sehr klein sind. Aus diesem Grunde bedient man sich zu ihrer Messung gerne sogenannter Integrationsverfahren, bei denen in mehreren aufeinander folgenden Zyklen kleine Ladungsmengen von dem Sensorelement, dessen Kapazitätswert relativ klein und veränderlich ist, auf einen Integrationskondensator mit einem bekannten festen und deutlich größeren Kapazitätswert übertragen werden.

Durch die deutsche Offenlegungsschrift DE 10 2010 041 464 A1 sowie durch das deutsche Gebrauchsmuster DE 299 24 441 U1 sind jeweils Verfahren zum Messen eines Kapazitätswertes eines kapazitiven Sensorelements gemäß dem Oberbegriff des Patentanspruchs 1 bekannt geworden. Bei den hier beschriebenen Verfahren zum Messen eines Kapazitätswertes handelt es sich um Integrationsverfahren der gerade angesprochenen Art, wobei ein Anschluss des Sensorelements mit einem ersten Anschluss des Integrationskondensators an einem gemeinsamen Schaltungsknoten elektrisch verbunden ist.

Zur Durchführung der Messung werden verschiedene Methoden verwendet. So kann beispielsweise nach Durchführung einer fest vorgegebenen Anzahl sogenannter Integrationszyklen die aus der Summe der dabei erfolgten Ladungstransfers resultierende, an dem Integrationskondensator anliegende Spannung mittels eines A/D-Wandlers gemessen und digitalisiert werden. Als Ergebnis der Messung wird die gemessene Spannung selbst, bzw. deren digitalisierter Wert, oder der aus diesem Wert und den bekannten konstanten Größen Kapazität des Integrationskondensators, Versorgungsspannung und Anzahl der Integrationszyklen berechnete Wert der Messkapazität verwendet. Alternativ hierzu kann aber auch in jedem einzelnen Integrationszyklus die an dem Integrationskondensator anliegende Spannung gemessen und bei Erreichen eines vorgegebenen Schwellwertes die Messung beendet werden. Die Messgröße ist in diesem Fall dann die bis zum Erreichen der Schwellwertspannung durchgeführte Anzahl von Integrationszyklen.

Ein Verfahren der zuletzt beschriebenen Art, bei dem eine Anzahl zuletzt durchgeführter Integrationszyklen die relevante Messgröße ist, ist z.B. durch die europäische Offenlegungsschrift EP 2 717 136 A1 offenbart.

Die Auflösung dieser Messverfahren - und damit die Grenze für die Unterscheidbarkeit zweier Zustände, bzw. Kapazitätswerte - ist maßgeblich durch die Auflösung des verwendeten A/D-Wandlers bestimmt. Durch einen A/D-Wandler können Spannungen nur in bestimmten diskreten Stufungen erfasst werden. Diese Stufen werden auch als Quantisierungsintervalle bezeichnet. Der zu messende Bereich wird also quantisiert, d.h. in diskrete Bereiche, in diesem Falle also Spannungsstufen aufgeteilt. Bei einer Messung wird dann der wahren, also analog gemessenen Spannung der Wert der nächst höheren oder tieferen Stufe als digitaler Messwert zugeordnet, je nachdem welcher dieser Stufen er näher liegt. Die Abweichung der wahren Spannung von der durch den A/D-Wandler ausgegebenen Spannungsstufe ist der Quantisierungsfehler. Sofern im Folgenden also von dem durch den A/D-Wandler gemessenen Spannungswert die Rede ist, ist damit jeweils der digitale Wert der durch den A/D-Wandler ausgegebenen Spannungsstufe gemeint.

Das Verfahren gemäß der vorliegenden Erfindung hat gegenüber dem zuvor beschriebenen den Vorteil, bei identischer Auflösung des A/D-Wandlers eine höhere Auflösung des Messergebnisses zu erreichen.

Dies gelingt erfindungsgemäß durch die Verfahrensschritte:
a) Festlegen einer Anzahl N durchzuführender Integrationszyklen auf einen Startwert Nstart und Bestimmen eines Endwertes N_{End} für die Anzahl N durchzuführender Integrationszyklen
b) Initialisieren eines Spannungssummenwerts U_{Ges} auf den Wert Null
c) Initialisieren der Zahl IZ durchgeführter Integrationszyklen auf den Wert Null
d) Verbinden des gemeinsamen Schaltungsknotens (3) und eines zweiten Anschlusses (2") des Integrationskondensators (2) mit einem Massepotential GND
e) Durchführen des Integrationsverfahrens bis die Zahl IZ durchgeführter Integrationszyklen die Anzahl N durchzuführender Integrationszyklen erreicht hat
f) Addieren des mittels des A/D-Wandlers aktuell bestimmten Spannungswertes U_{CI}(N) zu dem Spannungssummenwert U_{Ges}
g) Erhöhen der Anzahl N um einen Wert n, wobei n größer oder gleich 1 und kleiner als N_{Diff} = N_{End} - N_{Start} ist,
h) Wiederholung der Verfahrensschritte ab Schritt e) bis die Anzahl N den bestimmten Endwert N_{End} überschreitet
i) Auswertung des Spannungssummenwerts U_{Ges} als Messergebnis.

In einer vorteilhaften Ausgestaltung des erfindungsgemäßen Verfahrens ist vorgesehen, dass das Integrationsverfahren die folgenden Verfahrensschritte umfasst:
e1) Potentialfrei Halten des gemeinsamen Schaltungsknotens (3), wobei gleichzeitig eine bekannte Versorgungsspannung Uv an den zweiten Anschluss (2") des Integrationskondensators (2) angelegt wird
e2) Trennen der Versorgungsspannung Uv von dem zweite Anschluss (2") des Integrationskondensators (2), wobei gleichzeitig der gemeinsame Schaltungsknoten (3) mit dem Massepotential GND verbunden wird
e3) Erhöhen der Zahl IZ durchgeführter Integrationszyklen um den Wert Eins und Wiederholung der Verfahrensschritte ab Schritt e1) bis die Zahl IZ durchgeführter Integrationszyklen die aktuell vorgegebene Anzahl N durchzuführender Integrationszyklen erreicht hat
e4) Messen der an dem Integrationskondensator (2) anliegenden Spannung U_{CI}(N) mittels des A/D-Wandlers (4).

Nachfolgend ist die Erfindung unter Bezugnahme auf die beigefügte Zeichnung erläutert.

Dabei zeigen:
- **Fig. 1:**: a) eine schematische Darstellung der Messanordnung zur Durchführung des erfindungsgemäßen Verfahrens
b) eine Darstellung der zeitlichen Abfolge einer Integration mit N Integrationszyklen als Timing-Diagramm der Schalter aus a)
- **Fig. 2:**: den Verlauf der an dem Integrationskondensator anliegenden Spannung U_{CI}(N) als Funktion der Anzahl N der Integrationszyklen

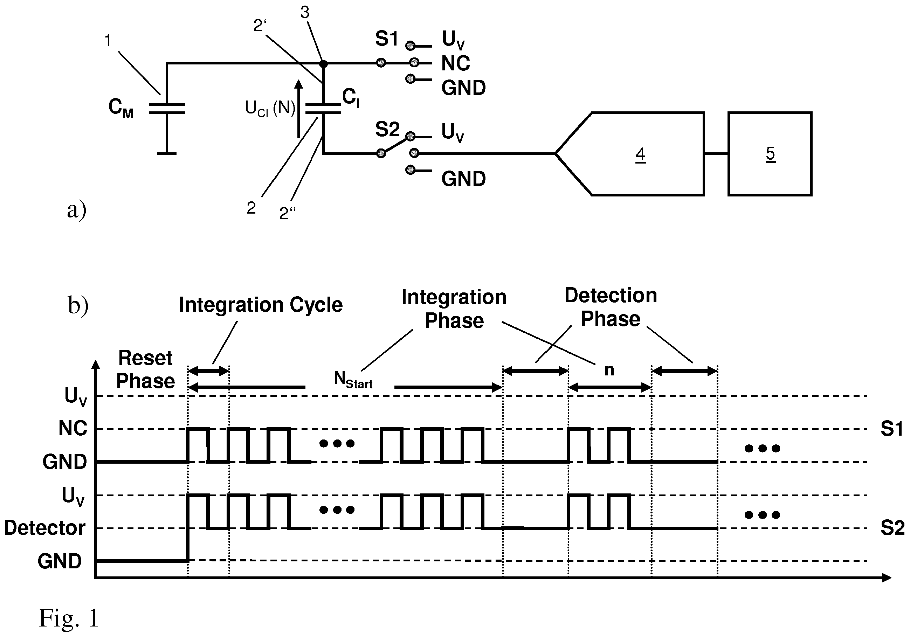

Die Zeichnung zeigt in Fig. 1 a) eine Messanordnung zur Durchführung des erfindungsgemäßen Verfahrens zum Messen eines Kapazitätswertes C_{M} eines kapazitiven Sensorelements 1 in einer schematischen Darstellung als Schaltbild. Das Sensorelement 1 bildet dabei beispielsweise einen Berührungssensor aus, etwa in Form einer Elektrode, die eine Eigenkapazität mit einem Kapazitätswert C_{M} bezüglich einem relativen Masse- oder Erdpotential hat. Bei Berührung oder Annäherung der Elektrode z.B. durch einen Finger des Benutzers ändert sich dieser Kapazitätswert C_{M} durch die Berührungskapazität, die dieser bezüglich dem Masse- oder Erdpotential aufweist.

Ein Anschluss des Sensorelements 1 ist an einem gemeinsamen Schaltungsknoten 3 mit einem ersten Anschluss 2' eines Integrationskondensators 2 elektrisch verbunden. Der bekannte Kapazitätswert Ci des Integrationskondensators 2 ist dabei groß gegenüber dem zu ermittelnden Kapazitätswert C_{M} des Sensorelements 1. Der gemeinsame Schaltungsknoten 3 ist weiterhin mit einem ersten Schalter S1 verbunden und über diesen je nach Schalterstellung wahlweise mit dem Masse- oder Erdpotential GND oder mit einer festen Versorgungsspannung Uv verbindbar oder potentialfrei, also offen gehalten (NC).

Ein zweiter Anschluss 2" des Integrationskondensators 2 ist elektrisch mit einem zweiten Schalter S2 verbunden und über diesen je nach Schalterstellung wahlweise mit dem Masse- oder Erdpotential GND, mit der festen Versorgungsspannung Uv oder mit einem Eingang eines A/D-Wandlers 4 verbindbar.

Zur Messung des Kapazitätswerts C_{M} wird ein grundsätzlich bekanntes Integrationsverfahren angewendet, bei dem in mehreren aufeinander folgenden Zyklen kleine Ladungsmengen von dem Sensorelement 1 auf den Integrationskondensator 2 übertragen werden. Nach einer Anzahl N dieser als Integrationszyklen bezeichneten Ladungstransfers wird die dann an dem Integrationskondensator 2 anliegende Spannung U_{CI}(N) mittels des A/D-Wandlers 4 gemessen. Die Spannung Uci(N) ist direkt proportional dem Kapazitätswert C_{M} und somit ein Maß für diesen. Ein beispielhafter Ablauf eines solchen Integrationsverfahrens wird anhand des in Fig. 1 b) wiedergegebenen Timing-Diagramms der Schalter S1 und S2 aus der Fig. 1 a) beschrieben, wobei die folgenden Schritte den Ablauf einen Integrationszyklus (Integration Cycle) wiedegeben:

Der mit dem ersten Anschluss 2' des Integrationskondensators 2 verbundene, gemeinsame Schaltungsknoten 3 wird mittels des Schalters S1 offen und somit potentialfrei gehalten, wobei gleichzeitig an den zweiten Anschluss 2" des Integrationskondensators 2 mittels des Schalters S2 die Versorgungsspannung Uv angelegt wird. Dann wird die Versorgungsspannung Uv mittels des Schalters S2 von dem zweiten Anschluss 2" des Integrationskondensators 2 getrennt und dieser potentialfrei gehalten, wobei gleichzeitig der gemeinsame Schaltungsknoten 3 mittels des Schalters S2 mit dem Massepotential GND verbunden wird.

Im Verlauf einer Messung werden die Schritte dieses Integrationszyklus wiederholt durchgeführt, und zwar so oft, bis die durchgeführte Zahl IZ von Integrationszyklen eine vorgegebene Anzahl N erreicht hat (Integration Phase).

Im Anschluss daran wird die an dem Integrationskondensator 2 nach diesen N Integrationszyklen anliegende Spannung U_{CI}(N) mittels des A/D-Wandlers 4 gemessen, indem der zweite Anschluss 2" des Integrationskondensators 2 mittels des Schalters S2 mit dem Eingang des A/D-Wandlers 4 verbunden wird (Detection Phase).

Der gemessene (digitale) Spannungswert U_{CI}(N) wird zur weiteren Verarbeitung und Auswertung an eine Steuer- und Auswerteeinrichtung 5 übermittelt. Die Steuer- und Auswerteeinrichtung 5 steuert den Ablauf des gesamten beschriebenen Verfahrens und umfasst dazu als zentrales Element etwa einen Mikrocontroller.

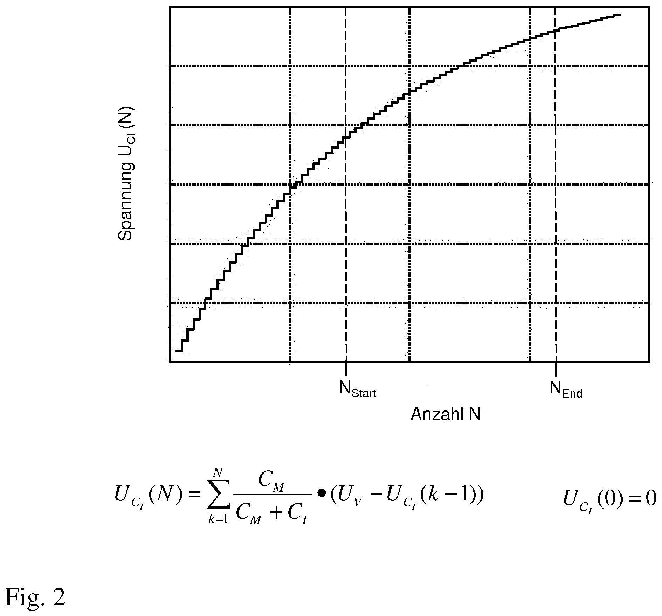

Gemäß der vorliegenden Erfindung ist die gerade beschriebene Messung mit N Integrationszyklen Bestandteil eines übergeordneten Ablaufs, der mehrere solcher Messungen mit jeweils unterschiedlichen Werten der durchzuführenden Anzahl N von Integrationszyklen umfasst, und zwar in der folgenden Weise, die auch aus der in Fig. 2 wiedergegebenen Darstellung des Verlaufs der an dem Integrationskondensator 2 anliegenden Spannung U_{CI}(N) als Funktion der Anzahl N der Integrationszyklen deutlich wird:
Zunächst wird die Anzahl N der durchzuführenden Integrationszyklen auf einen Startwert Nstart für die erste Messung im Rahmen des übergeordneten Ablaufs festgelegt. Gleichzeitig wird ein Ziel- bzw. Endwert N_{End} für die maximal durchzuführende Anzahl N von Integrationszyklen für die letzte Messung im Rahmen des übergeordneten Ablaufs bestimmt. Ein Spannungssummenwert U_{Ges} wird initialisiert auf den Wert Null.

Die Zahl IZ durchgeführter Integrationszyklen wird eingangs auf den Wert Null initialisiert. Weiterhin werden zur Initialisierung des Messvorgangs der mit dem ersten Anschluss 2' des Integrationskondensators 2 verbundene, gemeinsame Schaltungsknoten 3 und der zweite Anschluss 2" des Integrationskondensators 2 mit dem Massepotential GND verbunden, und damit die Spannung Uci über dem Integrationskondensator 2 zu Null gesetzt (Reset Phase).

Anschließend wird das oben beschriebene Integrationsverfahren ausgeführt, und zwar so lange, bis die Zahl IZ durchgeführter Integrationszyklen, die bei jeder Durchführung um den Wert Eins erhöht wird, die aktuell gültige Anzahl N durchzuführender Integrationszyklen erreicht hat. Mittels des A/D-Wandlers wird daraufhin der an dem Integrationskondensator 2 anliegende Spannungswert U_{CI}(N) bestimmt und dieser zu dem aktuell gültigen Spannungssummenwert U_{Ges} addiert.

Danach wird die Anzahl N der durchzuführenden Integrationszyklen um einen Wert n erhöht und die im vorhergehenden Absatz beschriebenen Schritte mit der neuen Anzahl N wiederholt. Dabei wird weder die Zahl IZ durchgeführter Integrationszyklen zurückgesetzt, noch wird die an dem Integrationskondensator 2 aktuell anliegende Spannung gelöscht, so dass effektiv nur weitere n Intergrationszyklen durchgeführt werden, und sich dabei die an dem Integrationskondensator 2 anliegende Spannung entsprechend weiter erhöht. Der Erhöhungswert n ist dabei mindestens gleich 1 und kleiner als die Differenz N_{Diff} = N_{End} - Nstart zwischen dem Startwert Nstart und dem Ziel- bzw. Endwert N_{End}. Um eine nicht zu geringe Menge von Messungen mit jeweils N Integrationszyklen als Bestandteil des übergeordneten Ablaufs zu erhalten, wird der Erhöhungswert n in der Regel deutlich kleiner als N_{Diff} gewählt werden. Er kann dabei entweder von Schritt zu Schritt variieren oder aber einen konstanten Wert von z.B. n=1, n=2, n=3 oder einen anderen Wert annehmen. Die Wiederholung des im vorhergehenden Absatz beschriebenen Schritts mit der neuen Anzahl N erfolgt so oft, bis die Anzahl N den eingangs bestimmten Endwert N_{End} überschreitet.

In Fig. 1b) ist dies beispielhaft für n=2 anhand der ersten beiden Integrations- und Detektionsphasen dargestellt. Die erste Integrationsphase umfasst dabei N_{Start} Integrationszyklen. Danach erfolgt die erste Detektionsphase, in der die an dem Integrationskondensator 2 aktuell anliegende Spannung U_{CI}(N_{Start}) gemessen wird.

In der darauf folgenden, zweiten Integrationsphase werden weitere n=2 Integrationszyklen ausgeführt, so dass die an dem Integrationskondensator 2 anliegende Spannung U_{CI}(N_{Start} + 2) nun aus insgesamt Nstart+ 2 Integrationszyklen resultiert. In dieser Weise wird die Messung fortgesetzt bis schließlich als letzter Wert die Spannung U_{CI}(N_{End}) gemessen wird.

Der bis zu diesem Zeitpunkt aus den jeweils gemessenen Spannungen U_{CI}(N) aufaddierte Spannungssummenwert U_{Ges} wird dann als Messergebnis ausgewertet.

In den Spannungssummenwert U_{Ges} gehen also, wie beschrieben, die einzelnen gemessenen Spannungswerte Uci(N) als Summanden ein. Jeder dieser Spannungswerte Uci(N) wurde dabei durch den A/D-Wandler 4 bestimmt und ist daher, wie bereits zuvor erläutert, mit einem Quantisierungsfehler behaftet. Dabei verläuft die Quantisierung linear über den Messbereich, d.h. die Stufenhöhe der durch den A/D-Wandler 4 ausgegebenen Spannungsstufen ist jeweils gleich. Da der Verlauf der an dem Integrationskondensator 2 anliegenden Spannung Uci(N) als Funktion der Anzahl N der Integrationszyklen hingegen, wie in Fig. 2 zu erkennen, nichtlinear ist, ergibt sich eine statistische Verteilung der Quantisierungsfehler, die in der Summe zu einer zumindest teilweisen Kompensation derselben führt.

## Patentansprüche

1. Verfahren zum Messen eines Kapazitätswertes C_{M} eines kapazitiven Sensorelements (1) mittels eines Integrationsverfahrens, wobei ein Anschluss des Sensorelements (1) mit einem ersten Anschluss (2') eines Integrationskondensators (2) mit einem bekannten Kapazitätswert C_{I}, welcher groß gegenüber dem Kapazitätswert C_{M} des Sensorelements (1) ist, an einem gemeinsamen Schaltungsknoten (3) elektrisch verbunden ist, und wobei nach einer Zahl IZ durchgeführter Integrationszyklen eine an dem Integrationskondensator (2) anliegende Spannung U_{CI} mittels eines A/D-Wandlers (4) gemessen wird, während der gemeinsamen Schaltungsknoten (3) mit einem Massepotential (GND) verbunden ist,
**gekennzeichnet durch** die Verfahrensschritte:
a) Festlegen einer Anzahl N durchzuführender Integrationszyklen auf einen Startwert N_{Start} und Bestimmen eines Endwertes N_{End} für die Anzahl N durchzuführender Integrationszyklen
b) Initialisieren eines Spannungssummenwerts U_{Ges} auf den Wert Null
c) Initialisieren der Zahl IZ durchgeführter Integrationszyklen auf den Wert Null
d) Verbinden des gemeinsamen Schaltungsknotens (3) und eines zweiten Anschlusses (2") des Integrationskondensators (2) mit dem Massepotential GND
e) Durchführen des Integrationsverfahrens bis die Zahl IZ durchgeführter Integrationszyklen die Anzahl N durchzuführender Integrationszyklen erreicht hat
f) Addieren des mittels des A/D-Wandlers aktuell bestimmten Spannungswertes U_{CI}(N) zu dem Spannungssummenwert U_{Ges}
g) Erhöhen der Anzahl N um einen Wert n, wobei n größer oder gleich 1 und kleiner als N_{Diff} = N_{End} - N_{Start} ist,
h) Wiederholung der Verfahrensschritte ab Schritt e) bis die Anzahl N den bestimmten Endwert N_{End} überschreitet
i) Auswertung des Spannungssummenwerts U_{Ges} als Messergebnis.

2. Verfahren nach Anspruch 1, wobei der Wert n der Erhöhung ein konstanter Wert ist.

3. Verfahren nach Anspruch 1, wobei der Wert n der Erhöhung von Schritt zu Schritt variiert.

4. Verfahren nach einem der Ansprüche 1 bis 3, wobei das Integrationsverfahren die folgenden Verfahrensschritte umfasst:
e1) Potentialfrei Halten des gemeinsamen Schaltungsknotens (3), wobei gleichzeitig eine bekannte Versorgungsspannung Uv an den zweiten Anschluss (2") des Integrationskondensators (2) angelegt wird
e2) Trennen der Versorgungsspannung Uv von dem zweite Anschluss (2") des Integrationskondensators (2), wobei gleichzeitig der gemeinsame Schaltungsknoten (3) mit dem Massepotential GND verbunden wird
e3) Erhöhen der Zahl IZ durchgeführter Integrationszyklen um den Wert Eins und Wiederholung der Verfahrensschritte ab Schritt e1) bis die Zahl IZ durchgeführter Integrationszyklen die aktuell vorgegebene Anzahl N durchzuführender Integrationszyklen erreicht hat
e4) Messen der an dem Integrationskondensator (2) anliegenden Spannung U_{CI}(N) mittels des A/D-Wandlers (4).

## Claims

1. Method for measuring a capacitance value C_{M} of a capacitive sensor element (1) by means of an integration method, wherein a terminal of the sensor element (1) is electrically connected to a first terminal (2') of an integration capacitor (2) having a known capacitance value C_{I} which is large compared with the capacitance value C_{M} of the sensor element (1), is electrically connected at a common circuit node (3), and wherein, after a number IZ of integration cycles carried out, a voltage U_{CI} applied to the integration capacitor (2) is measured by means of an A/D converter (4) while the common circuit node (3) is connected to a ground potential (GND), **characterized by** the method steps:
a) Fixing a number N of integration cycles to be performed to a start value N_{Start} and determining a final value N_{End} for the number N of integration cycles to be performed
b) Initializing a voltage sum value U_{Ges} to the value zero
c) Initializing the number IZ of performed integration cycles to the value zero
d) Connecting the common node (3) and a second terminal (2") of the integration capacitor (2) to the ground potential GND
e) Carrying out the integration procedure until the number IZ of integration cycles has reached the number N of integration cycles to be performed
f) Adding the voltage value U_{CI}(N) currently determined by the A/D converter to the voltage value U_{CI}(N) to the voltage sum value U_{Ges}
g) Increasing the number N by a value n, where n is greater than or equal to 1 and is smaller than N_{Diff} = N_{End} - N_{Start},
h) Repeating the process steps from step e) until the number N exceeds the determined final value N_{End}
i) Evaluation of the voltage sum value U_{Ges} as the measurement result.

2. Method according to claim 1, wherein the value n of the increase is a constant value.

3. Method according to claim 1, wherein the value n of the increase varies from step to step.

4. Method according to any one of claims 1 to 3, wherein the integration method comprises the following method steps:
e1) Keeping the common circuit node (3) potential-free, whereby simultaneously applying a known supply voltage Uv to the second terminal (2") of the integration capacitor (2) is applied
e2) Disconnecting the supply voltage Uv from the second terminal (2") of the integration capacitor (2), at the same time connecting the common node (3) is connected to the ground potential GND
e3) Increasing the number IZ of integration cycles performed by the value one and repeating the process steps from step e1) until the number IZ of integration cycles performed exceeds the currently specified number N of integration cycles to be performed.
e4) Measuring the voltage applied to the integration capacitor (2) U_{CI}(N) by means of the A/D converter (4).

## Revendications

1. Procédé de mesure d'une valeur de capacité C_{M} d'un élément de détection capacitif (1) au moyen d'un procédé d'intégration, dans lequel une borne de l'élément de détection (1) est reliée à une première borne (2') d'un condensateur d'intégration (2) ayant une valeur de capacité connue C_{I} qui est grande par rapport à la valeur de capacité C_{M} de l'élément de détection (1), est connecté électriquement à un noeud de circuit commun (3), et dans lequel, après un nombre IZ de cycles d'intégration effectués, une tension U_{CI} appliquée au condensateur d'intégration (2) est mesurée au moyen d'un convertisseur A/N (4), tandis que le noeud de circuit commun (3) est connecté à un potentiel de masse (GND),
**caractérisé par** les étapes de procédé :
a) fixation d'un nombre N de cycles d'intégration à effectuer à une valeur de début valeur de départ N_{Start} et détermination d'une valeur finale N_{End} pour le nombre N de cycles d'intégration
b) Initialisation d'une valeur de somme de tensions Uses à la valeur zéro
c) Initialisation du nombre IZ de cycles d'intégration exécutés à la valeur zéro
d) connexion du noeud de circuit commun (3) et d'un deuxième borne (2") du condensateur d'intégration (2) au potentiel de GND.
e) exécuter le processus d'intégration jusqu'à ce que le nombre IZ de cycles d'intégration exécutés soit égal au nombre de cycles d'intégration atteint le nombre N de cycles d'intégration à effectuer
f) additionner la valeur UCI déterminée actuellement par le convertisseur A/N à la valeur U_{CI}(N) à la valeur de la somme des tensions Uses
g) augmenter le nombre N d'une valeur n, où n est supérieur ou égal à 1 et est inférieur à N_{Diff} = N_{End} - N_{Start},
h) répétition des étapes du procédé à partir de l'étape e) jusqu'à ce que le nombre N atteigne la valeur dépasse la valeur finale déterminée N_{End}
i) évaluation de la valeur de la somme des tensions Uses comme résultat de mesure.

2. Procédé selon la revendication 1, dans lequel la valeur n de l'augmentation est une valeur constante.

3. Procédé selon la revendication 1, dans lequel la valeur n de l'augmentation varie d'une étape à l'autre.

4. Procédé selon l'une quelconque des revendications 1 à 3, dans lequel le procédé d'intégration comprend les étapes de procédé suivantes :
e1) maintenir le noeud de circuit commun (3) libre de potentiel, tout en simultanément, une tension d'alimentation connue Uv est appliquée à la deuxième (2") du condensateur d'intégration (2) est appliquée.
e2) déconnexion de la tension d'alimentation Uv de la deuxième borne (2") du condensateur de puissance condensateur d'intégration (2), le noeud de connexion commun étant simultanément noeud de circuit (3) est relié au potentiel de masse GND
e3) augmentation du nombre IZ de cycles d'intégration réalisés de la valeur un et la répétition des étapes du procédé à partir de l'étape e1) jusqu'à ce que le nombre IZ de cycles d'intégration exécutés dépasse le nombre actuellement prédéfini N de cycles d'intégration à effectuer
e4) mesure de la tension appliquée au condensateur d'intégration (2) U_{CI}(N) au moyen du convertisseur A/N (4).
